Europäisches Patentamt

European Patent Office

Office européen des brevets

(11) Veröffentlichungsnummer: **0 231 459 B1**

(12) **EUROPÄISCHE PATENTSCHRIFT**

(45) Veröffentlichungstag der Patentschrift: **26.06.91**

(51) Int. Cl.⁵: **G01R 31/14**, G01R 31/04

(21) Anmeldenummer: **86116205.5**

(22) Anmeldetag: **21.11.86**

(54) **Prüfvorrichtung zur Spannungsprüfung von Kabeln und Kabelgarnituren.**

(30) Priorität: 28.08.86 DE 3629352
09.01.86 DE 3600391

(43) Veröffentlichungstag der Anmeldung:
**12.08.87 Patentblatt 87/33**

(45) Bekanntmachung des Hinweises auf die
Patenterteilung:
**26.06.91 Patentblatt 91/26**

(84) Benannte Vertragsstaaten:
**AT BE CH DE FR GB IT LI LU NL SE**

(56) Entgegenhaltungen:
**DD-A- 228 361**
**DD-A- 248 665**

(73) Patentinhaber: **Salzgitter Elektronik Gesellschaft mit beschränkter Haftung
Postfach 160
W-2302 Flintbek(DE)**

(72) Erfinder: **Lefeldt, Ekkehard
Lindenstrasse 31
W-2351 Bornhöved(DE)**

(74) Vertreter: **Hansmann, Dierk, Dipl.-Ing.
Jessenstrasse 4
W-2000 Hamburg 50(DE)**

Rank Xerox (UK) Business Services

## Beschreibung

Die Erfindung bezieht sich auf eine Prüfvorrichtung zur Spannungsprüfung von Kabeln und Kabelgarnituren für Hoch- und Mittelspannung, insbesondere von Kabeln mit PE- oder VPE-Isolation, bestehend aus einem Gleichspannungsprüfgerät, das über einen Schalter das Kabel auf eine gewünschte Spannung auflädt.

Kabel werden zur Überprüfung ihrer Betriebssicherheit nach der Verlegung, nach einer Reparatur oder in bestimmten zeitlichen Abständen mit Spannungen beaufschlagt, die über den maximalen Betriebsspannungen liegen. Dabei sind Art und Höhe dieser Prüfspannungen in entsprechenden Vorschriften festgelegt. Bezogen auf die Ader-Erde-Spannung des Kabels kann beispielsweise mit zweifacher effektiver Wechselspannung 50 Hz oder mit sechsfacher Gleichspannung geprüft werden. Die Gleichspannungsprüfung wird im allgemeinen vorgezogen, da sie mit erheblich geringerem Aufwand als eine Wechselspannungsprüfung durchführbar ist. Bei einem Gleichspannungsprüfgerät ist nur der Sprüh- und Ableitstrom von wenigen Milliampere aufzubringen, während eine Wechselspannungsprüfanlage eine von der Kabelkapazität abhängige relativ hohe Blindleistung aufzubringen hat. Selbst wenn nur eine Ader des Kabels zur Zeit geprüft wird, können Blindströme in einer Größenordnung von über 10 Ampere auftreten. Wechselspannungsprüfanlagen sind deshalb aufgrund der Kosten, Abmessungen und des Gewichtes sehr aufwendig und somit nur wenig verbreitet.

Ferner kann die Gleichspannungsprüfung von PE-isolierten Kabeln problematisch werden, da feldverzerrende Raumladungen entstehen können. Das Kabel kann dann zusammen mit der Umpolbeanspruchung bei einem Überschlag zusätzlich geschädigt werden. Der Überschlag braucht nicht einmal im Kabel selbst, sondern kann auch in einer Muffe oder im Endverschluß stattfinden.

Um einerseits Raumladungen zu vermeiden, aber andererseits mit geringerem Aufwand auszukommen als er für eine Wechselspannungsprüfung mit Betriebsfrequenz notwendig ist, sind Prüfgeneratoren mit sehr niedriger Frequenz, sogenannten VLF-Generatoren, bekannt geworden. Sie arbeiten mit einer Frequenz um 0,1 Hz. Aber auch mit einer Prüffrequenz von 0,1 Hz muß das Kabel innerhalb von 10 sec zweimal geladen und wieder entladen werden. Das ist gegenüber einer reinen Gleichspannungsprüfung bei großen Kabelkapazitäten noch sehr aufwendig, denn es müssen erhebliche Energien entweder im Prüfgenerator gespeichert oder nach jeder Entladung in Wärme umgesetzt werden.

Aufgabe der Erfindung ist es, eine einfache Prüfvorrichtung der im Oberbegriff des Anspruchs 1 genannten Art zu schaffen, die mit geringem Aufwand sowohl die Prüfung neu installierter Kabelgarnituren als auch die Feststellung der Schäden an der Kabelisolation ermöglicht und damit eine Erhöhung der Betriebssicherheit gewährleistet.

Die Lösung dieser Aufgabe erfolgt erfindungsgemäß dadurch, daß das geladene Kabel über periodisch umschaltbar Schaltelemente des Schalters in einer Schaltstellung über eine Drossel und einen vorgeschalteten Gleichrichter auf die Gegenpolarität umschwingt und daß das Kabel in einer weiteren Schaltstellung auf die ursprüngliche Polarität, gegebenenfalls über die Drossel und einen umgekehrt gepolten Gleichrichter, zurückschwingt, wobei das Kabel in der einen Schaltstellung der Schaltelemente durch das zugeordnete Gleichspannungsprüfgerät mit positiver oder negativer Polarität jeweils zur Deckung der Umschwing- und Ableitverluste auf die ursprüngliche Spannung nachladbar ist.

Eine einfache Ausbildung mit zwei Gleichrichtern in einer Schaltungsanordnung mit Polaritätsumkehr besteht darin, daß die Schaltelemente durch einen Umschalter gebildet sind.

Um eine günstige Ausbildung zur Vermeidung von Umpolbeanspruchungen zu schaffen, wird vorgeschlagen, daß die Drossel derart bemessen ist, daß der Umschwingvorgang mit einem Spannungsgradienten ohne Bildung einer meßbaren Wanderwelle abläuft.

Zur Erzielung einer Prüfspannung, die sich zeitlich fortlaufend ändert, um auch von sogenannten water-trees herrührende Hohlkanäle durch einen gezielten Durchschlag zu ermitteln, wird vorgeschlagen, daß jeweils nach dem Umschalten des Schaltelements das Kabel über ein weiteres Schaltelement direkt mit der Drossel bis zur Entladung verbunden ist und nach Öffnen des weiteren Schaltelements das Kabel wieder auf die vom Schaltelement vorgegebene Polarität über die zugeordneten Prüfgeräteteile aufladbar ist. Die damit hervorgerufene zeitlich fortlaufende Spannungsänderung führt zu intensiven Gasentladungen, und durch Erosion entsteht in relativ kurzer Zeit ein vollständiger Durchschlag.

Um eine erfindungsgemäße Anordnung einfach zu gestalten, wird vorgeschlagen daß die Schaltelemente durch einen steuerbaren Schaltrotor mit Kontakten gebildet sind, denen korrespondierende ortsfeste Kontakte zugeordnet sind, wobei zwischen zwei Kontakten des Schaltrotors ein Gleichrichter angeordnet ist sowie von einem Kontakt zu einem weiteren Kontakt eine Kontaktbrücke besteht und der Schaltrotor mit seinen Kontakten derart einstellbar ist, daß sich in einer Halbperiode der Rotorumdrehung eine Schaltstellung ergibt, in der nach Umschwingen auf die Ladepolarität über das Gleichspannungsprüfgerät das Kabel auf eine Spannung geladen bzw. nachgeladen wird, und beim Durchlauf des Schaltrotors in eine weitere Schaltstellung für die andere Halbperiode das Kabel über Gleichrichter und Drossel auf Gegenpolarität umschwingt sowie eine vollständige Trennung vom Kabel einstellbar ist.

Durch die Trennung in der zweiten Schaltstellung entsteht auch keine zusätzliche Entladung des Kabels über Beschaltungswiderstände und dergleichen, so daß nach dem Umschwingen über die Drossel die Spannung in der betreffenden Halbwelle nahezu erhalten bleibt und somit kein Nachladen erforderlich ist und ein Prüfgerät für diese Halbwelle entfallen kann.

Zum Ausgleich von Spannungszeitflächendifferenzen zwischen beiden Halbwellen, wird vorgeschlagen, daß das Gleichspannungsprüfgerät über einen vom Schaltrotor steuerbaren Schalter einschaltbar ist und daß das Gleichspannungsprüfgerät mit einer zeitlichen Verzögerung nach dem Umschwingen auf Ladepolarität einschaltbar ist, wobei die zeitliche Verzögerung von der auszugleichenden Spannungszeitflächendifferenz bestimmt wird.

Zur Vermeidung zu großer Spannungsdifferenzen in der gesamten Anordnung unter Berücksichtigung von geladenen Kaskadenkondensatoren im Gleichspannungsprüfgerät ist vorgesehen, daß nach dem Laden des Kabels, jedoch vor dem Umschwingen auf Gegenpolarität, mittels zugeordneter Kontakte beim Umlauf des Schaltrotors durch entsprechende Kontaktgabe über den Gleichrichter und die Drossel eine Entladung des Gleichspannungsprüfgerätes einstellbar ist.

Um den Umschwingvorgang im Hinblick auf die Vermeidung von Wanderwellen zu verlangsamen und die Spannungshaltung in der Halbwelle ohne Nachladung zu verbessern, wird vorgeschlagen, daß parallel zum Kabel ein Stützkondensator geschaltet ist.

In der Zeichnung sind Ausführungsbeispiele der Erfindung schematisch dargestellt. Es zeigen:

Fig. 1   ein Grundprinzip einer Schaltungsanordnung mit einem Umschalter,

Fig. 2   eine Schaltungsanordnung für eine zeitlich fortlaufend veränderte Spannung mit einem Umschalter,

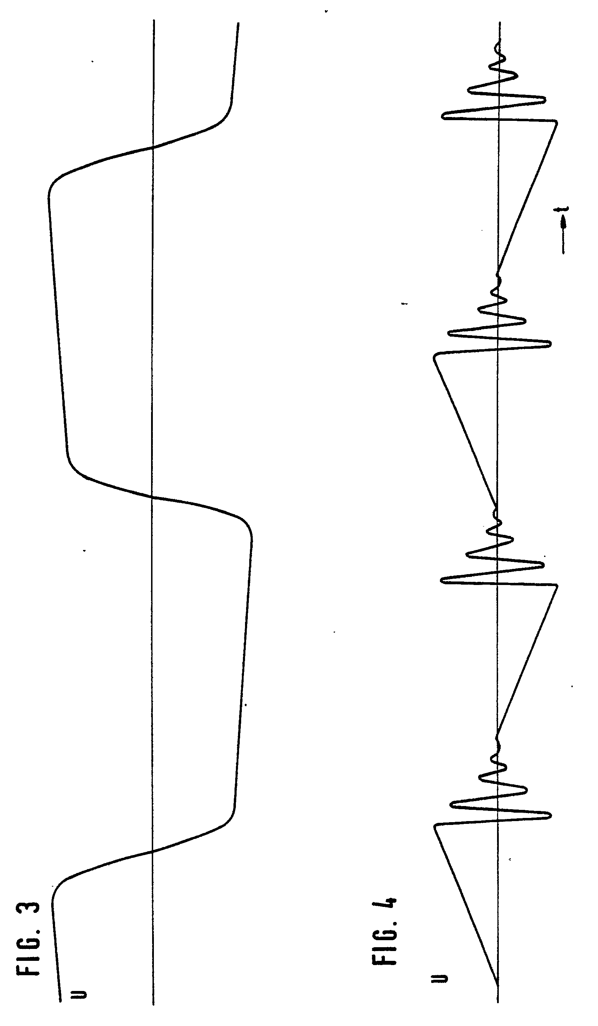

Fig. 3   ein Spannungs-Zeitdiagramm der Prüfspannung für eine Kabelgarniturenprüfung gemäß Fig. 1.

Fig. 4   ein Spannungs-Zeitdiagramm der Prüfspannung für eine Kabelprüfung gemäß Fig. 2,

Fig. 5   eine weitere Ausführung einer Schaltungsanordnung mit einem Schaltrotor in einer Ladeposition als Schaltstellung für eine Halbperiode,

Fig. 6   eine Zwischenstellung des Schaltrotors gemäß Fig. 5 zur Entladung des Prüfgerätes,

Fig. 7   eine Zwischenstellung des Schaltrotors gemäß Fig. 5 zum Umschwingen des Kabels auf Gegenpolarität.

Fig. 8   eine Schaltstellung des Schaltrotors gemäß Fig. 5 mit einer vollständigen Trennung vom Kabel für eine andere Halbperiode,

Fig. 9   ein Spannungs-Zeitdiagramm der Prüfspannung mit einem Schaltrotor und einem Prüfgerät.

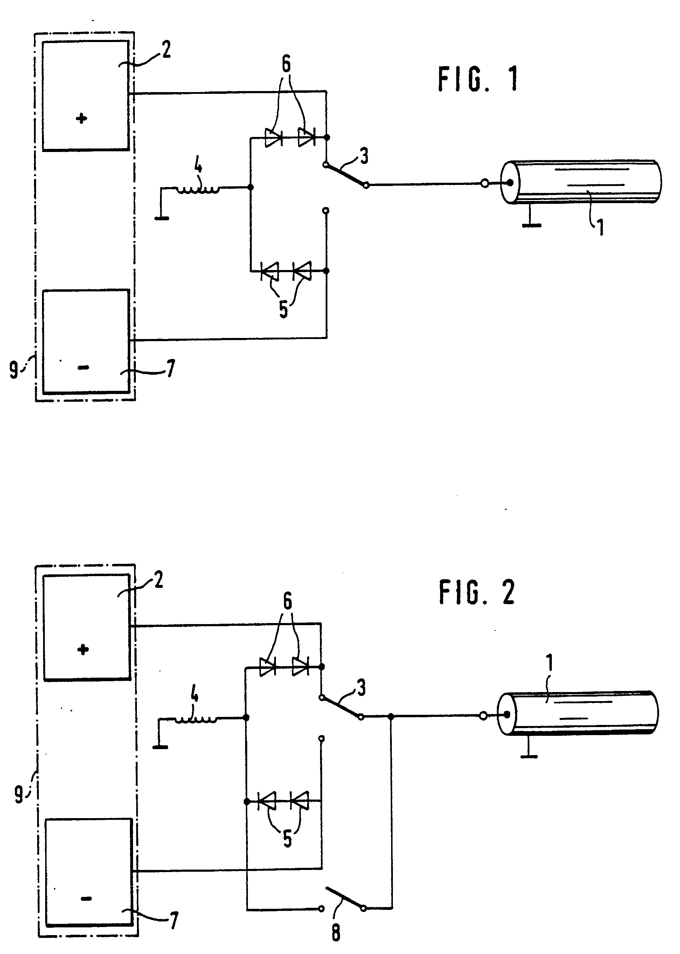

Die dargestellte Schaltungsanordnung gemäß Fig. 1 und 2 besteht aus einem Gleichspannungsprüfgerät 9 mit je einem Prüfgeräteteil für positive 2 und negative 7 Gleichspannung, die je nach Stellung eines Schalters 3 ein Kabel 1 positiv oder negativ laden. Beim Umschalten des Schalters 3 schwingt das Kabel 1 über eine zugeordnete Drossel 4 und einen Gleichrichter 5 bzw. einen Gleichrichter 6 auf Gegenpolarität um.

Die Umschwing- und Ableitverluste werden durch Nachladen aus dem zugehörigen Prüfgeräteteil 2 oder 7 gedeckt. Diese Betriebsweise gilt insbesondere für eine Kabelgarniturenprüfung.

Für eine Kabelprüfung nach der Schaltungsanordnung gemäß Fig. 2 wird nach jedem Umschalten des Schalters 3 ein Schalter 8 in Parallelschaltung zum Schalter 3 solange geschlossen bis sich das Kabel 1 schwingend entladen hat. Nach dem Öffnen des Schalters 8 lädt sich dann das Kabel 1 wieder auf die vom Schalter 3 vorgegebene Polarität auf. Durch diese Schaltungsanordnung wird das Kabel 1 einer zeitlich sich fortlaufend veränderten Spannung ausgesetzt, wie es in Fig. 4 dargestellt ist.

Der Schalter 3 wird normalerweise durch ein Zeitglied entsprechend den Erfordernissen betätigt, während der Schalter 8 nach jeder Betätigung des Schalters 3 über ein gesondertes Zeitglied bis zur vollständigen Entladung geschlossen bleibt.

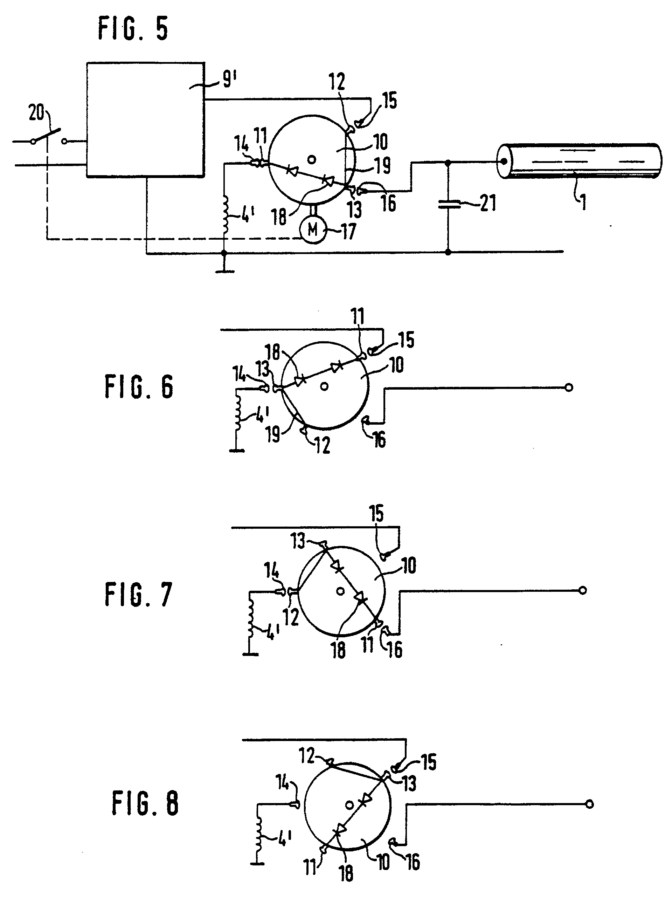

In einer weiteren Ausführungsform gemäß Fig. 5 bis 8 ist als Schaltelement ein Schaltrotor 10 angeordnet, der gegeneinander versetzte Kontakte 11,12 und 13 aufweist, denen korrespondierende, ortsfeste Kontakte 14,15 und 16 zugeordnet sind. Der Schaltrotor 10 wird dabei über einen Motor 17 entsprechend den Erfordernissen gedreht.

Der Schaltrotor 10 trägt Gleichrichter 18, die zwischen den Kontakten 11 und 13 angeordnet sind, und zwischen dem Kontakt 13 und dem Kontakt 12 ist zusätzlich eine Kontaktbrücke 19 angeordnet. Während einer Halbperiode verharrt der Schaltrotor 10 in der Position gemäß Fig. 5. In dieser Stellung wird das Kabel 1, nachdem es auf die Ladepolarität umgeschwungen ist, über die Kontakte 13,16 die Kontaktbrücke 19 und die Kontakte 12,15 durch das Prüfgerät 9' auf die ge-

wünschte Spannung geladen bzw. nachgeladen und über die Kontakte 11 und 14 die Drossel 4' über die Gleichrichter 18 verbunden. Anschließend wird der Schaltrotor 10 über den Motor 17 über die Stellungen gemäß Fig. 6 und 7 in die Stellung gemäß Fig. 8 gedreht und verharrt in dieser Position während der folgenden Halbperiode.

Während des Durchlaufs des Schaltrotors 10 erfolgt in der Stellung gemäß Fig. 6 über die Kontakte 11,15 und 13,14 eine Entladung des Prüfgerätes 9' mit seinen Kaskadenkondensatoren über die Gleichrichter 18 und die Drossel 4'. Beim Durchlauf des Schaltrotors 10 durch die in Fig. 7 dargestellte Stellung schwingt das Kabel 1 auf die Gegenpolarität um.

In der Position gemäß Fig. 8 ist das Kabel 1 völlig von der Schaltungsanordnung getrennt und es bleibt die Spannung in der betreffenden Halbwelle nach dem Umschwingen über die Drossel 4' nahezu erhalten. Es kann nur eine geringfügige Entladung über einen extrem hohen Eigenwiderstand erfolgen. Nach Ablauf der Verharrzeit wird der Schaltrotor in die Stellung gemäß Fig. 5 zurückgedreht. Dabei schwingt das Kabel 1 wieder in die Ladepolarität um und ist mit dem Prüfgerät 9' verbunden.

Um verbleibende Spannungszeitflächendifferenzen zwischen beiden Halbwellen auszugleichen, wird das Prüfgerät 9' über einen Schalter 20 eingeschaltet, der über den Schaltrotor 10 steuerbar ist und nur während der Ladephase mit einer zeitlichen Verzögerung nach dem Umschwingen auf Ladepolarität eingeschaltet wird. Die zeitliche Verzögerung wird dabei von der auszugleichenden Spannungszeitflächendifferenz bestimmt.

Weiterhin ist parallel zum Kabel 1 ein Stützkondensator 21 angeordnet, um den Umschwingvorgang zu verlangsamen, daß keine Wanderwellen entstehen. Ein solcher Stützkondensator 21 dient auch zur Verbesserung der Spannungshaltung in der Halbperiode, in der nicht nachgeladen wird.

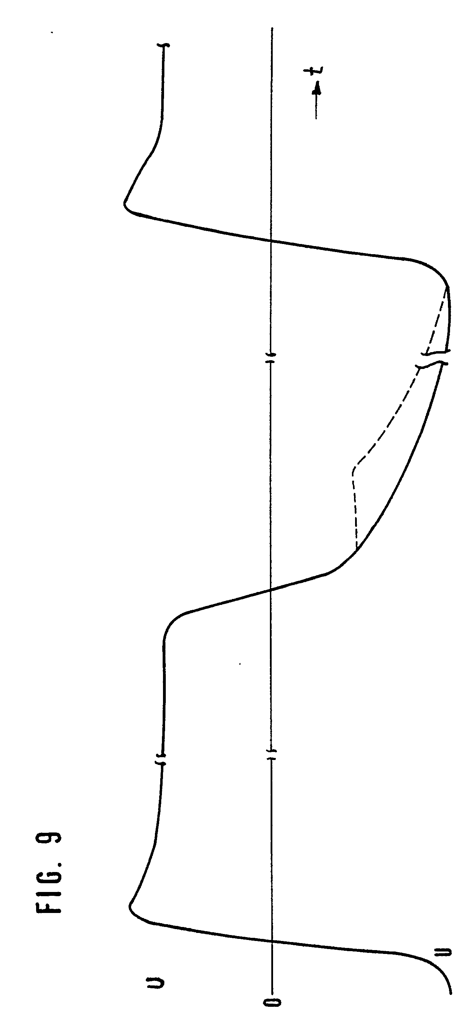

Das dargestellte Spannungs-Zeitdiagramm gemäß Fig.9 beginnt mit dem Umschwingvorgang, nachdem das Kabel 1 nachgeladen wurde. Nach diesem Umschwingen wird das Kabel 1 zunächst durch eventuelle Sprühverluste an den Endverschlüssen etwas stärker entladen. Der sich dann anschließende sehr langsame Spannungsrückgang wird von der sehr großen Eigenentladezeitkonstante bestimmt. Nach Ablauf dieser Halbperiode schwingt das Kabel 1 auf die entgegengepolte, d. h. auf die Ladehalbperiode um. Die Spannung steigt durch Nachladen wieder auf den ursprünglichen Wert an. Die Kurvenform, die sich ergibt, wenn zum Ausgleich unterschiedlicher Spannungszeitflächen verzögert nachgeladen wird, ist gestrichelt dargestellt.

## Ansprüche

1. Prüfvorrichtung zur Spannungsprüfung von Kabeln und Kabelgarnituren für Hoch- und Mittelspannung, insbesondere von Kabeln mit PE- oder VPE-Isolation, bestehend aus einem Gleichspannungsprüfgerät (9), das über einen Schalter das Kabel auf eine gewünschte Spannung auflädt, dadurch gekennzeichnet, daß das geladene Kabel (1) über periodisch umschaltbare Schaltelemente (3,8,10) des Schalters in einer Schaltstellung über eine Drossel (4) und einen vorgeschalteten Gleichrichter (5) auf die Gegenpolarität umschwingt und daß das Kabel (1) in einer weiteren Schaltstellung auf die ursprüngliche Polarität, gegebenenfalls über die Drossel (4) und einen umgekehrt gepolten Gleichrichter (6), zurückschwingt, wobei das Kabel (1) in der einen Schaltstellung der Schaltelemente (3,8,10) durch das zugeordnete Gleichspannungsprüfgerät (9) mit positiver oder negativer Polarität jeweils zur Deckung der Umschwing- und Ableitverluste auf die ursprüngliche Spannung nachladbar ist.

2. Prüfvorrichtung nach Anspruch 1, dadurch gekennzeichnet, daß die Schaltelemente durch einen Umschalter (3) gebildet sind.

3. Prüfvorrichtung nach Anspruch 1 oder 2, dadurch gekennzeichnet, daß die Drossel (4) derart bemessen ist, daß der Umschwingvorgang mit einem Spannungsgradienten ohne Bildung einer meßbaren Wanderwelle abläuft.

4. Prüfvorrichtung nach Anspruch 1 oder 3, dadurch gekennzeichnet, daß jeweils nach dem Umschalten des Schaltelements (3) das Kabel (1) über ein weiteres Schaltelement (8) direkt mit der Drossel (4) bis zur Entladung verbunden ist und nach Öffnen des weiteren Schaltelements (8) das Kabel (1) wieder auf die vom Schaltelement (3) vorgegebene Polarität über das zugeordnete Prüfgerät (9) aufladbar ist.

5. Prüfvorrichtung nach Anspruch 1, dadurch gekennzeichnet, daß die Schaltelemente durch einen steuerbaren Schaltrotor (10) mit Kontakten (11,12,13) gebildet sind, denen korrespondierende ortsfeste Kontakte (14,15,16) zugeordnet sind, wobei zwischen zwei Kontakten (11,13) des Schaltrotors (10) ein Gleichrichter (18) angeordnet ist sowie von einem Kontakt (13) zu einem weiteren Kontakt (12) eine Kontaktbrücke (19) besteht und der Schaltrotor (10) mit seinen Kontakten (11,12,13) derart einstellbar ist, daß sich in einer Halbperiode der Rotorumdrehung eine Schaltstellung ergibt, in der nach Umschwingen auf die Ladepolarität über das Gleichspannungsprüfgerät (9') das Kabel (1) auf eine Spannung geladen bzw. nachgeladen wird und beim Durchlauf des Schaltrotors (10) in eine weitere Schaltstellung für die andere Halbperiode das Kabel über Gleichrichter (18) und Drossel (4') auf Gegenpolarität umschwingt sowie eine vollständige Trennung vom Kabel (1) einstellbar ist.

6. Prüfvorrichtung nach Anspruch 5, dadurch gekennzeichnet, daß das Gleichspannungsprüfgerät (9') über einen vom Schaltrotor (10) steuerbaren Schalter (20) einschaltbar ist und daß das Gleichspannungsprüfgerät (9') mit einer zeitlichen Verzögerung nach dem Umschwingen auf Ladepolarität einschaltbar ist, wobei die zeitliche Verzögerung von der auszugleichenden Spannungszeitflächendifferenz bestimmt wird.

7. Prüfvorrichtung nach Anspruch 5 oder 6, dadurch gekennzeichnet, daß nach dem Laden des Kabels (1), jedoch vor dem Umschwingen auf Gegenpolarität, mittels zugeordneter Kontakte (11,15 und 13,14) beim Umlauf des Schaltrotors (10) durch entsprechende Kontaktgabe über den Gleichrichter (18) und die Drossel (4') eine Entladung des Gleichspannungsprüfgerätes (9') einstellbar ist.

8. Prüfvorrichtung nach einem der Ansprüche 5 bis 7, dadurch gekennzeichnet, daß parallel zum Kabel (1) ein Stützkondensator (21) geschaltet ist.

**Claims**

1. Test apparatus for voltage testing cables and cable accessories for high and medium voltage, in particular cables with PE or XLPE insulation, comprising a d.c. voltage test appliance (9) which by means of a switch charges the cable to a desired voltage, characterised in that the charged cable (1) by means of periodically selectable switching elements (3, 8, 10) of the switch in one switch setting reverses polarity by way of a choke (4) and a series-connected connected rectifier (5), and that the cable (1) in a further switch setting returns to the original polarity, possibly by way of the choke (4) and an inversely polarised rectifier (6), with the cable (1) in the one switch setting of the switching elements (3, 8, 10) being rechargeable to the original voltage by the associated d.c. voltage appliance (9) with a positive or negative polarity to cover the polarity reversal losses and the discharge losses respectively.

2. Test apparatus according to claim 1, characterised in that the switching elements are formed by a changeover switch (3).

3. Test apparatus according to claim 1 or 2, characterised in that the choke (4) is so dimensioned that the polarity reversal process is effected with a potential gradient without development of a measurable travelling wave.

4. Test apparatus according to claim 1 or 3, characterised in that after each changeover of the switching element (3) the cable (1) is connected by a further switching element (8) directly to the choke (4) up to discharge and, after opening of the further switching element (8), the cable (1) is rechargeable by the associated test appliance (9) to the polarity predetermined by the switching element (3).

5. Test apparatus according to claim 1, characterised in that the switching elements are formed by a controllable switching rotor (10) having contacts (11, 12, 13) with which corresponding stationary contacts (14, 15, 16) are associated, with a rectifier (18) being disposed between two contacts (11, 13) of the switching rotor (10) and there being a contact bridge from one contact (13) to another contact (12) and the switching rotor (10) with its contacts (11, 12, 13) being so adjustable that in one half-period of the rotor rotation a switch setting arises in which, after reversal to the charging polarity, the cable (1) is charged or re-charged by the d.c. voltage test appliance (9') to a voltage and upon the switching rotor (10) moving on into a further switch setting for the other half-period the cable reverses polarity by way of rectifier (18) and choke (4') and a complete separation from the cable (1) is adjustable.

6. Test apparatus according to claim 5, characterised in that the d.c. voltage test appliance (9') may be switched on by means of a switch (20) controllable by the switching rotor (10), and that the d.c. voltage test appliance (9') is operable with a time delay after the reversal to charging polarity, said time delay being determined by the voltage-time integral variation to be compensated.

7. Test apparatus according to claim 5 or 6, characterised in that, after charging of the cable (1) but prior to polarity reversal, a discharge of the d.c. voltage test appliance (9') is adjustable by means of associated contacts (11, 15 and 13, 14) during rotation of the switching rotor (10) as a result of corresponding contact making by way of the rectifier (18) and the choke (4').

8. Test apparatus according to one of claims 5 to 7, characterised in that a back-up capacitor (21) is connected in parallel to the cable (1).

**Revendications**

1. Dispositif pour tester la tension de câbles et systèmes de câbles pour haute et moyenne tension et, en particulier, pour câbles à isolation PE et VPE , constitué d'un appareil d'essai à tension continue (9) qui charge le câble à une tension souhaitée par l'intermédiaire d'un commutateur, caractérisé en ce que le câble chargé (1) est commuté à la polarité opposée par des éléments de commutation (3, 8, 10) du commutateur périodiquement commutable dans une position de commutation par une bobine (4) et un redresseur (5) montés en amont et que le câble (1) revient à la polarité initiale, éventuellement par la bobine (4) et un redresseur (6) à polarité inverse, tandis que le câble (1) peut être chargé à-la tension initiale par l'appareil d'essai à tension continue (9) avec une polarité positive ou négative, afin de compenser chaque fois les pertes de commutation et de fuite.

2. Dispositif d'essai selon la revendication 1, caractérisé en ce que les éléments de commutation sont constitués par un inverseur (3).

3. Dispositif d'essai selon la revendication 1 ou 2, caractérisé en ce que la bobine (4) est dimensionnée de façon à ce que le processus de commutation se déroule avec un gradient de tension, sans formation d'une onde progressive mesurable.

4. Dispositif d'essai selon la revendication 1 ou 3, caractérisé en ce que le câble (1) est connecté directement à la bobine (4) par un autre élément de commutation (8) jusqu'à la décharge après la commutation de l'élément de commutation (3) et que, après l'ouverture de l'autre élément de commutation (8), le câble (1) peut être rechargé par l'appareil d'essai correspondant (9) à la polarité imposée par l'élément de commutation (3).

5. Dispositif d'essai selon la revendication 1, caractérisé en ce que les éléments de commutation sont constitués par un rotor de commutation (10) pouvant être commandé avec des contacts (11, 12, 13) auxquels correspondent des contacts fixes (14, 15, 16) tandis que, entre deux contacts (11, 13) du rotor de commutation (10) est disposé un redresseur (18) ainsi qu'un pont de contact (19) d'un contact (13) jusqu'à un autre contact (12), et que le rotor de commutation (10) peut être réglé avec ses contacts (11, 12, 13), qu'une position de commutation se présente au cours d'une demi-période de la rotation du rotor pendant laquelle, après commutation à la polarité de chargement par l'appareil d'essai à tension continue (9'), le câble (1) est chargé ou rechargé à une tension et que, après que le rotor de commutation (10) est arrivé à une autre position de commutation pour l'autre demi-période , le câble (1) est commuté à la polarité opposée par le redresseur (18) et la bobine (4') et qu'une coupure complète du câble (1) peut être réalisée.

6. Dispositif d'essai selon la revendication 5, caractérisé en ce que l'appareil d'essai à tension continue (9') peut être enclenché par un commutateur (20) pouvant être commandé par le rotor de commutation (10) et que l'appareil d'essai à tension continue (9') peut être enclenché avec un retard de temps après la commutation à la polarité de chargement, tandis que le retard de temps est déterminé par la différence de surface tension-temps à compenser.

7. Dispositif d'essai selon la revendication 5 ou 6, caractérisé en ce qu'une décharge de l'appareil d'essai à tension continue (9') peut être réalisée,après le chargement du câble (1) mais avant la commutation à la polarité opposée, au moyen de contacts correspondants (11, 15 et 13, 14) au cours de la rotation du rotor de commutation (10) grâce à des contacts correspondants, au moyen du redresseur (18) et de la bobine (4').

8. Dispositif d'essai selon l'une des revendications 5 à 7, caractérisé en ce qu'un condensateur auxiliaire (21) est monté en parallèle avec le câble 1.

FIG. 1

FIG. 2

EP 0 231 459 B1

FIG. 3

U

FIG. 4

U

t

8

EP 0 231 459 B1

FIG. 5

FIG. 6

FIG. 7

FIG. 8

FIG. 9

EP 0 231 459 B1